# EUROPEAN PATENT APPLICATION

(11) **EP 4 401 109 A1**
(43) Date of publication of application: **17.07.2024**
(21) Application number: 22867324.0
(22) Date of filing: 05.09.2022
(51) Int. Cl.: H01J 37/073, H01J 37/22, H01J 37/244, H01J 37/252, H01J 37/28

(54) **METHOD FOR CREATING DETECTION DATA IN ELECTRON BEAM APPLICATION DEVICE, METHOD FOR SYNTHESIZING IMAGE OF OBJECT BEING IRRADIATED, PROGRAM, RECORDING MEDIUM, AND ELECTRON BEAM APPLICATION DEVICE**

(30) Priority: 07.09.2021 JP 2021145169
(71) Applicant: Photo Electron Soul Inc., Nagoya-shi, Aichi 460-0008 (JP)
(72) Inventor: NISHITANI, Tomohiro, Nagoya-shi, Aichi 460-0008 (JP)
(74) Representative: Heyerhoff Geiger GmbH & Co. KG
(86) International application number: PCT/JP2022/033257
(87) International publication number: WO 2023/038002

(57) **Abstract**

An object is to provide a creation method of detection data and an image composition method for an irradiation target in an electron beam applicator, a program, a storage medium, and an electron beam applicator based on a novel principle. In the creation method of detection data in an electron beam applicator, the electron beam applicator includes a light source, a photocathode configured to generate releasable electrons in response to receiving light from the light source, an anode configured to form an electric field between the photocathode and the anode and extract the releasable electrons by the formed electric field to form an electron beam, a detector configured to detect emission quantity data related to emission from an irradiation target irradiated with the electron beam, and a control unit, and the creation method of detection data includes: an electron beam irradiation step of irradiating an irradiation region of the irradiation target with the electron beam; a detection step of detecting, by the detector, the emission quantity data related to emission from the irradiation region irradiated with the electron beam and generating a detection signal; a quantity of light adjustment step of adjusting a quantity of light reaching the photocathode from the light source so that a signal intensity of the detection signal is a preset value; a step of repeating the electron beam irradiation step, the detection step, and the quantity of light adjustment step until the signal intensity of the detection signal becomes the preset value; and a detection data output step of outputting the quantity of light adjustment data where the signal intensity of the detection signal is the preset value as detection data on the irradiation region.

## Description

### [Technical Field]

The disclosure in the present application relates to a creation method of detection data and an image composition method for an irradiation target in an electron beam applicator, a program, a storage medium, and an electron beam applicator.

### [Background Art]

Electron guns equipped with a photocathode and electron beam applicators, such as an electron microscope and an inspection device, including such an electron gun are known. For example, Patent Literature 1 discloses a sample inspection device with a photocathode that is irradiated with excitation light from a light source and emits an electron beam. The sample inspection device described in Patent Literature 1 discloses a detector which detects electrons emitted from a sample irradiated with an electron beam to generate a detection signal and a method to remove a noise signal that is not a signal emitted from a sample by extracting a signal with a frequency corresponding to a modulation frequency of frequency-modulated light emitted from the light source out of the detection signal. Further, Patent Literature 1 discloses that the quantity of light of pulsed light is adjusted when in a situation where the sample is susceptible to thermal damage or the like.

Further, Patent Literature 2 discloses that, in a detection unit to detect secondary electrons emitted from an irradiation region of an inspection device, the detection sensitivity is adjusted in accordance with projection magnification or the like.

### [Citation List]

### [Patent Literature]

Patent Literature 1: Japanese Patent No. 6604649
Patent Literature 1: Japanese Patent Application Laid-Open No. H11-242943

### [Summary of Invention]

### [Technical Problem]

The adjustment of detection sensitivity of the detection unit is performed manually or the like with reference to a detection result of secondary electrons emitted from the irradiation region due to irradiation with an electron beam, for example. Therefore, for example, when capturing the entire image of an irradiation region or performing adjustment such as enlarging and capturing a partial image of an irradiation region, there is a problem of a detector with a large dynamic range of detection sensitivity being required.

The present application has been made in order to solve the above problem, and according to an intensive study, it has been newly found that, as illustrated in the principle described later, (1) in a photocathode, it is possible to easily adjust the intensity (electron quantity) of an electron beam to be emitted by adjusting the quantity of light of received excitation light, (2) the quantity of light reaching the photocathode is adjusted so that the signal intensity of the detection signal of an emission quantity related to emission from the irradiation region is a preset value, (3) since quantity of light adjustment data when the signal intensity of the detection signal is the preset value is data reflecting the sample state of the irradiation region, the quantity of light adjustment data can be used as detection data on the irradiation region, and (4) therefore, even with a small dynamic range of sensitivity of the detector, detection data on the irradiation region is obtained.

The disclosure in the present application is to provide a creation method of detection data and an image composition method for an irradiation target in an electron beam applicator, a program, a storage medium, and an electron beam applicator based on a novel principle.

### [Solution to Problem]

The present application relates to a creation method of detection data and an image composition method for an irradiation target in an electron beam applicator, a program, a storage medium, and an electron beam applicator as illustrated below.

(1) A creation method of detection data in an electron beam applicator, wherein the electron beam applicator includes
   a light source,
   a photocathode configured to generate releasable electrons in response to receiving light from the light source,
   an anode configured to form an electric field between the photocathode and the anode and extract the releasable electrons by the formed electric field to form an electron beam,
   a detector configured to detect emission quantity data related to emission from an irradiation target irradiated with the electron beam, and
   a control unit,
   the creation method of detection data including:
      an electron beam irradiation step of irradiating an irradiation region of the irradiation target with the electron beam;
      a detection step of detecting, by the detector, the emission quantity data related to emission from the irradiation region irradiated with the electron beam and generating a detection signal;
      a quantity of light adjustment step of adjusting a quantity of light reaching the photocathode from the light source so that a signal intensity of the detection signal is a preset value;
      a step of repeating the electron beam irradiation step, the detection step, and the quantity of light adjustment step until the signal intensity of the detection signal becomes the preset value; and
      a detection data output step of outputting the quantity of light adjustment data where the signal intensity of the detection signal is the preset value as detection data on the irradiation region.
   (2) The creation method of detection data according to (1) above, wherein the preset value is the same value regardless of a location in the irradiation region.
   (3) The creation method of detection data according to (1) above, wherein the electron beam applicator is
      a scanning electron microscope,
      an electron beam inspection device,
      an Auger electron spectrometer,
      a cathodoluminescence device,
      an X-ray analyzer,
      a transmission electron microscope, or
      a scanning transmission electron microscope.
   (4) The creation method of detection data according to (2) above, wherein the electron beam applicator is
      a scanning electron microscope,
      an electron beam inspection device,
      an Auger electron spectrometer,
      a cathodoluminescence device,
      an X-ray analyzer,
      a transmission electron microscope, or
      a scanning transmission electron microscope.
   (5) An image composition method for an irradiation target in an electron beam applicator, the image composition method including:
      an image composition step of compositing an image of an irradiation region of the irradiation target from detection data obtained by the creation method of detection data according to (1) above.
   (6) An image composition method for an irradiation target in an electron beam applicator, the image composition method including:
      an image composition step of compositing an image of an irradiation region of the irradiation target from detection data obtained by the creation method of detection data according to (2) above.
   (7) An image composition method for an irradiation target in an electron beam applicator, the image composition method including:
      an image composition step of compositing an image of an irradiation region of the irradiation target from detection data obtained by the creation method of detection data according to (3) above.
   (8) An image composition method for an irradiation target in an electron beam applicator, the image composition method including:
      an image composition step of compositing an image of an irradiation region of the irradiation target from detection data obtained by the creation method of detection data according to (4) above.
   (9) A program that causes the control unit of the electron beam applicator to perform each step according to any one of (1) to (8) above.
   (10) A computer readable storage medium storing the program according to (9) above.
   (11) An electron beam applicator including:
      a light source;
      a photocathode configured to generate releasable electrons in response to receiving light from the light source;
      an anode configured to form an electric field between the photocathode and the anode and extract the releasable electrons by the formed electric field to form an electron beam;
      a detector configured to detect emission quantity data related to emission from an irradiation target irradiated with the electron beam; and
      a control unit,
      wherein the control unit implements control to perform
      an electron beam irradiation step of irradiating an irradiation region of the irradiation target with the electron beam,
      a detection step of detecting, by the detector, the emission quantity data related to emission from the irradiation region irradiated with the electron beam and generating a detection signal,
      a quantity of light adjustment step of adjusting a quantity of light reaching the photocathode from the light source so that a signal intensity of the detection signal is a preset value,
      a step of repeating the electron beam irradiation step, the detection step, and the quantity of light adjustment step until the signal intensity of the detection signal becomes the preset value, and
      a detection data output step of outputting the quantity of light adjustment data where the signal intensity of the detection signal is the preset value as detection data on the irradiation region.
   (12) The electron beam applicator according to (11) above, wherein the preset value is the same value regardless of a location in the irradiation region.
   (13) The electron beam applicator according to (11) or (12) above, wherein the control unit implements control to perform an image composition step of compositing an image of an irradiation region of the irradiation target from the detection data.
   (14) The electron beam applicator according to (11) or (12) above, wherein the electron beam applicator is
      a scanning electron microscope,
      an electron beam inspection device,
      an Auger electron spectrometer,
      a cathodoluminescence device,
      an X-ray analyzer,
      a transmission electron microscope, or
      a scanning transmission electron microscope.
   (15) The electron beam applicator according to (13) above, wherein the electron beam applicator is
      a scanning electron microscope,
      an electron beam inspection device,
      an Auger electron spectrometer,
      a cathodoluminescence device,
      an X-ray analyzer,
      a transmission electron microscope, or
      a scanning transmission electron microscope.

### [Advantageous Effect]

With the use of the creation method of detection data and the image composition method for an irradiation target in the electron beam applicator, the program, the storage medium, and the electron beam applicator based on a novel principle disclosed in the present application, detection data on the irradiation region is obtained even with a small dynamic range of sensitivity of the detector.

### [Brief Description of Drawings]

[FIG. 1] FIG. 1 is a diagram schematically illustrating an electron beam applicator 1 according to an embodiment.
[FIG. 2A] FIG. 2A is a diagram illustrating an overview of adjustment of detection sensitivity in a conventional electron beam applicator.
[FIG. 2B] FIG. 2B is a diagram illustrating an overview of adjustment of detection sensitivity in the conventional electron beam applicator.
[FIG. 2C] FIG. 2C is a diagram illustrating an overview of adjustment of detection sensitivity in the conventional electron beam applicator.
[FIG. 2D] FIG. 2D is a diagram illustrating an overview of adjustment of detection sensitivity in the conventional electron beam applicator.
[FIG. 3A] FIG. 3A is a diagram illustrating the principle of a detection data creation method disclosed in the present application.
[FIG. 3B] FIG. 3B is a diagram illustrating the principle of the detection data creation method disclosed in the present application.
[FIG. 3C] FIG. 3C is a diagram illustrating the principle of the detection data creation method disclosed in the present application.
[FIG. 4] FIG. 4 is a flowchart of the detection data creation method.
[FIG. 5] FIG. 5 includes photographs substituted for drawings in which the upper photograph represents image data composited in Example 2 and the lower photograph represents image data captured in Comparative example 2.

### [Description of Embodiments]

A creation method of detection data (hereafter, which may be referred to as "detection data creation method") and an image composition method for an irradiation target in an electron beam applicator, a program, a storage medium, and an electron beam applicator based on a new principle will be described in detail below with reference to the drawings. Note that, in the present specification, members having the same type of functions are labeled with the same or similar references. Further, duplicated description for the members labeled with the same or similar references may be omitted.

Further, the position, size, range, or the like of respective components illustrated in the drawings may be depicted differently from the actual position, size, range, or the like for easier understanding. Thus, the disclosure in the present application is not necessarily limited to the position, size, range, or the like disclosed in the drawings.

### [Embodiment of Electron Beam Applicator and Detection Data Creation Method]

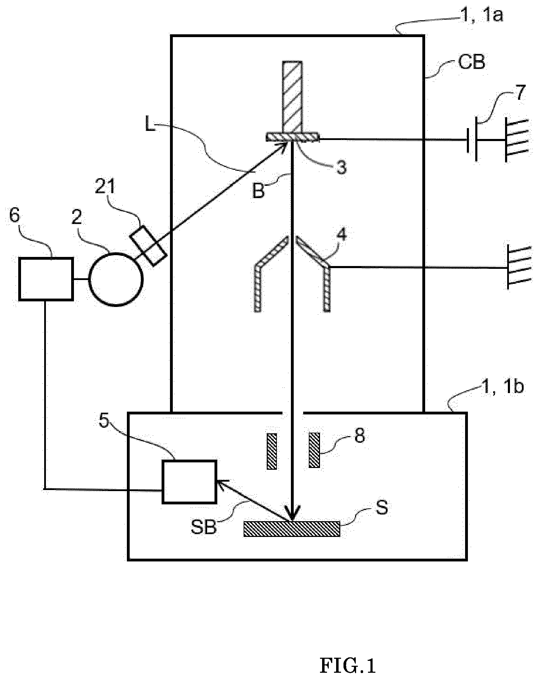

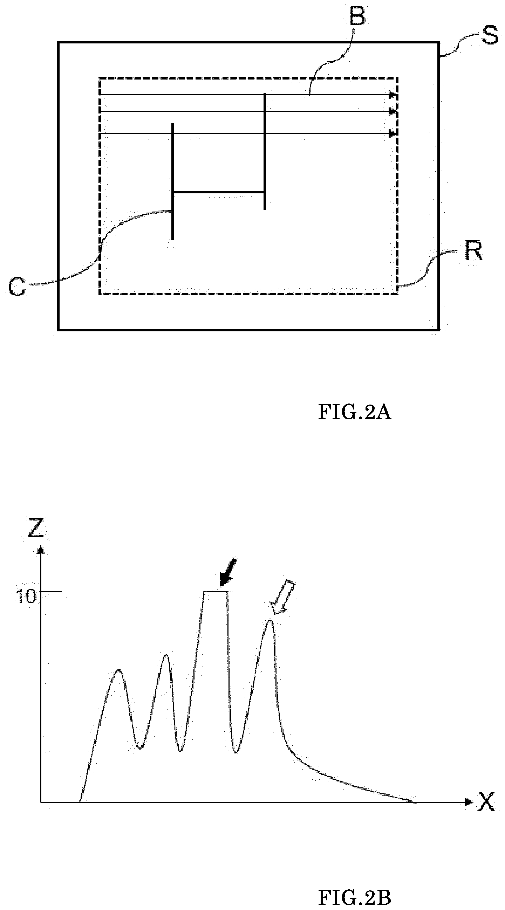

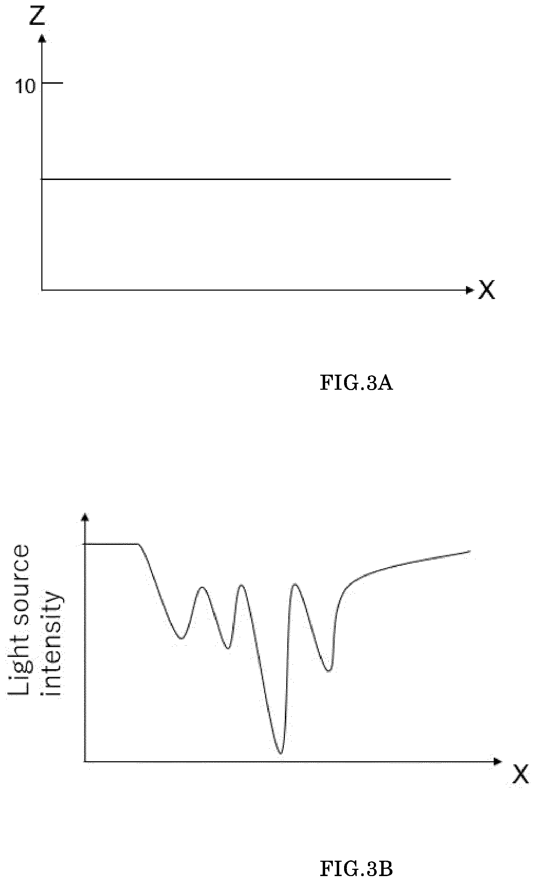

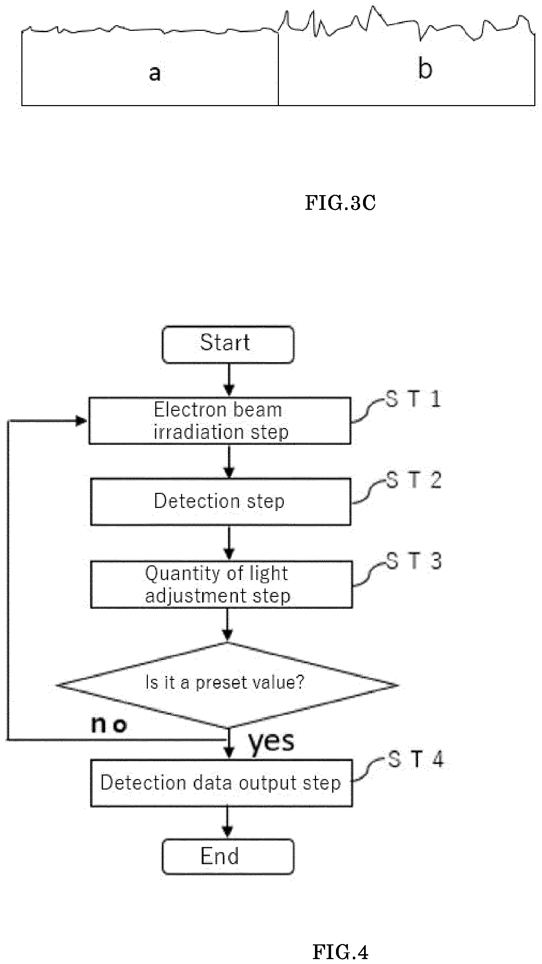

Embodiments of the electron beam applicator and the detection data creation method will be described with reference to FIG. 1 to FIG. 4. FIG. 1 is a diagram schematically illustrating an electron beam applicator 1 according to the embodiment. FIG. 2A to FIG. 2D are diagrams illustrating the overview of adjustment of detection sensitivity in the conventional electron beam applicator. FIG. 3A to FIG. 3C are diagrams illustrating the principle of the detection data creation method disclosed in the present application. FIG. 4 is a flowchart of the detection data creation method.

The embodiment of the electron beam applicator 1 illustrated in FIG. 1 includes at least a light source 2, a photocathode 3, an anode 4, a detector 5, and a control unit 6. Note that FIG. 1 illustrates an example in which the electron beam applicator 1 is formed separately of an electron gun portion 1a and a counterpart device 1b (the remaining portion of the electron beam applicator 1 when the electron gun portion 1a is removed). Alternatively, the electron beam applicator 1 may be formed in an integrated manner. Further, the electron beam applicator 1 may be optionally, additionally provided with a power supply 7 for generating an electric field between the photocathode 3 and the anode 4 and an electron beam deflector 8 for scanning the electron beam B on an irradiation target S. Furthermore, although depiction is omitted, a known component in accordance with the type of the electron beam applicator 1 may be included.

The light source 2 is not particularly limited as long as it can irradiate the photocathode 3 with excitation light L to cause emission of the electron beam B. The light source 2 may be, for example, a high power (watt class), high frequency (several hundred MHz), ultrashort pulse laser light source, a relatively inexpensive laser diode, an LED, or the like. The excitation light L for irradiation can be either pulsed light or continuous light and can be adjusted as appropriate in accordance with purposes. Note that, in the example illustrated in FIG. 1, the light source 2 is arranged outside a vacuum chamber CB, and a first face (a face on the anode 4 side) side of the photocathode 3 is irradiated with the excitation light L. Alternatively, the light source 2 may be arranged inside the vacuum chamber CB. Further, a second face (a face on the opposite side of the anode 4) side of the photocathode 3 may be irradiated with the excitation light L.

The photocathode 3 generates releasable electrons in response to receiving the excitation light L irradiated from the light source 2. The principle of the photocathode 3 generating releasable electrons in response to receiving the excitation light L is well known (for example, see Japanese Patent No. 5808021 and the like).

The photocathode 3 is formed of a substrate of quartz glass, sapphire glass, or the like and a photocathode film (not illustrated) adhered to the first face (the face on the anode 4 side) of the substrate. The photocathode material for forming the photocathode film is not particularly limited as long as it can generate releasable electrons in response to irradiation with excitation light and may be a material requiring EA surface treatment, a material not requiring EA surface treatment, or the like. The material requiring EA surface treatment may be, for example, Group III-V semiconductor materials or Group II-VI semiconductor materials. Specifically, the material may be AlN, Ce₂Te, GaN, a compound of one or more types of alkaline metals and Sb, or AlAs, GaP, GaAs, GaSb, InAs, or the like, and a mixed crystal thereof, or the like. The material may be a metal as another example and specifically may be Mg, Cu, Nb, LaB₆, SeB₆, Ag, or the like. The photocathode 3 can be fabricated by applying EA surface treatment on the photocathode material described above. For the photocathode 3, suitable selection of the semiconductor material or the structure thereof makes it possible not only to select excitation light in a range from near-ultraviolet to infrared wavelengths in accordance with gap energy of the semiconductor but also to achieve electron beam source performance (quantum yield, durability, monochromaticity, time response, spin polarization) in accordance with the use of the electron beam.

Further, the material not requiring EA surface treatment may be, for example, a single metal, an alloy, or a metal compound of Cu, Mg, Sm, Tb, Y, or the like or diamond, WBaO, Cs₂Te, or the like. The photocathode not requiring EA surface treatment can be fabricated by a known method (for example, see Japanese Patent No. 3537779 and the like). The content disclosed in Japanese Patent No. 3537779 is incorporated in the present specification in its entirety by reference.

Note that, regarding the reference to "photocathode" and "cathode" in the present specification, "photocathode" may be used when the reference in question means emission of the electron beam, and "cathode" may be used when the reference in question means the counter electrode of an "anode". Regarding the reference numeral, however, "3" is used for both cases of "photocathode" and "cathode".

The anode 4 is not particularly limited as long as it can generate an electric field together with the cathode 3, and any anode 4 generally used in the field of electron guns can be used. When an electric field is formed between the cathode 3 and the anode 4, the releasable electrons generated by irradiation with the excitation light L are extracted from the photocathode 3, and thereby the electron beam B is formed.

Although FIG. 1 illustrates the example in which the power supply 7 is connected to the cathode 3 in order to form an electric field between the cathode 3 and the anode 4, the arrangement of the power supply 7 is not particularly limited as long as a potential difference occurs between the cathode 3 and the anode 4.

The detector 5 detects emission quantity data SB related to emission from the irradiation target S irradiated with the electron beam B. The emission quantity data SB means a signal issued from the irradiation target S in response to irradiation with the electron beam B and may represent, for example, secondary electrons, backscattered electrons, characteristic X-rays, Auger electrons, cathodoluminescence, transmitted electrons, or the like. The detector 5 is not particularly limited as long as it can detect such emission quantity data SB, and a known detector and a known detection method may be used.

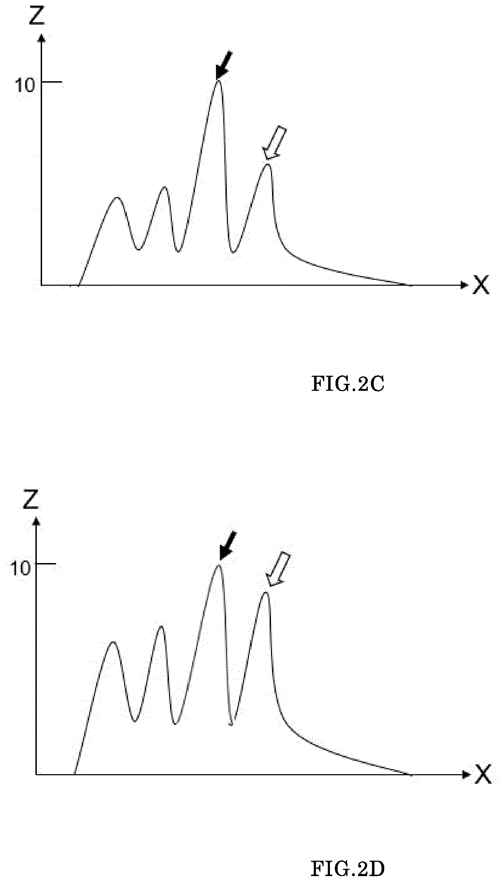

Next, the principle of the detection data creation method (in other words, details of control of the control unit 6) disclosed in the present application will be described with reference to FIG. 2 and FIG. 3 in comparison with the conventional art. FIG. 2A is a diagram of the irradiation target S when viewed from the photocathode 3 side. The electron beam applicator 1 illustrated in FIG. 2A irradiates the irradiation region R of the irradiation target S with the electron beam B linearly while deflecting the electron beam B. When unevenness due to a circuit C or the like is formed in the irradiation region R and when the intensity of the electron beam B being irradiated is the same, the emission quantity data SB related to emission from the uneven portion differs from the remaining portion. Therefore, in the conventional electron beam applicator 1, as illustrated in FIG. 2B, it is possible to detect the uneven portion as a difference in intensity (Z) of the detection signal by detecting the emission quantity data SB in time-series (X) by using the detector 5.

In the conventional electron beam applicator 1, when the intensity of the emission quantity data SB of a certain portion of the irradiation region R exceeds the signal maximum value that can be processed by the detector 5 (the dynamic range, 10 on the vertical axis in the example illustrated in FIG. 2B), the peak that is supposed to be obtained may not be detected as indicated by the arrow in FIG. 2B. In such a case, in the conventional electron beam applicator 1, to enable detection of the peak that is supposed to be obtained, the detection sensitivity of the detector 5 is adjusted. However, when the detection sensitivity is adjusted (reduced) in order to enable detection of the peak that is supposed to be obtained, although the peak indicated by the arrow in FIG. 2B can be detected as illustrated in FIG. 2C, there is a problem of a reduced detection intensity for the peak indicated by the white arrow.

Thus, in the conventional electron beam applicator 1, as illustrated in FIG. 2D, data within the dynamic range of the data illustrated in FIG. 2B may be used without change, and a data portion exceeding the dynamic range in FIG. 2B may be composited by using the data with the reduced detection sensitivity as illustrated in FIG. 2C. In such a case, however, there is a problem in the example illustrated in FIG. 2D, for example, that the peaks of the arrow and the white arrow are substantially the same and this does not accurately reflect the state of the actual irradiation region R.

In contrast, in the detection data creation method disclosed in the present application, as illustrated in FIG. 3A, the quantity of light reaching the photocathode 3 from the light source 2 is adjusted so that the signal intensity of the detection signal of the emission quantity data SB related to emission from the irradiation region R is a preset value. Note that FIG. 3A illustrates an example in which the preset value of the signal intensity of the detection signal is the same regardless of the location in the irradiation region R. The signal intensity of the detection signal being the same despite the presence of unevenness in the irradiation region R means that the quantity of light reaching the photocathode 3 from the light source 2 is adjusted in accordance with the unevenness of the irradiation region R, as illustrated in FIG. 3B. Therefore, the quantity of light adjustment data illustrated in FIG. 3B in which the quantity of light reaching the photocathode 3 is adjusted so that the signal intensity of the detection signal illustrated in FIG. 3A is the same is data reflecting the sample state of the irradiation region R. Thus, the quantity of light adjustment data can be used as detection data on the irradiation region R.

For example, when the electron beam applicator 1 is an electron beam inspection device to inspect a semiconductor circuit or the like, because the detection data is the data reflecting the sample state of the irradiation region R as described above, the presence or absence of a defect or the like in the semiconductor circuit can be inspected based on the detection data. Further, when the electron beam applicator 1 is a scanning electron microscope (SEM), the image of the irradiation region R can be composited based on the detection data. Note that the detection data is the data reflecting the sample state of the irradiation region R, and thus, in the image composition, while image composition can be performed so as to accurately reflect the sample state of the irradiation region R, image composition may be performed with partial processing as illustrated in FIG. 2D where necessary. The image composition method is not particularly limited as long as it is apparent how the composite image reflects the detection data.

Note that, although FIG. 3A illustrates an example in which the preset value for the signal intensity of the detection signal is the same regardless of the location in the irradiation region R, the preset value may not be the same. For example, when the irradiation region R includes regions of apparently different sample states as indicated by "a" and "b" in FIG. 3C, a different value depending on the region may be used as the preset value.

Further, when the electron beam applicator 1 is a scanning electron microscope, it may be desirable to reduce the amount of an electron beam irradiated on a particular region in order to avoid charging-up of the irradiation region R. As illustrated for the detection data creation method described later, the control unit 6 repeats an electron beam irradiation step, a detection step, and a quantity of light adjustment step until the signal intensity of the detection signal becomes the preset value. That is, since the control unit 6 performs feedback control on the quantity of light based on the detection signal, it is possible to always store the relationship between the irradiation position of the electron beam B, the detection signal, and the quantity of light. Therefore, even when the detection signal is reduced (in other words, the preset value is different) for only a particular region, the data reflecting the sample state of the irradiation region R is obtained by analyzing the detection data based on the relationship between the stored irradiation position of the electron beam B, the stored detection signal, and the stored quantity of light.

Note that the control unit 6 of the electron beam applicator 1 disclosed in the present application is not required to always adjust the quantity of light reaching the photocathode 3 from the light source 2 so that the signal intensity of the detection signal of the emission quantity data SB related to emission from the irradiation region R is the preset value. For example, the control unit 6 may switch the control to perform the control disclosed in the present application only when the intensity of the emission quantity data SB exceeds the maximum value of the signal that can be processed by the detector 5 (dynamic range) or exceeds a preset threshold. That is, when the intensity of the emission quantity data SB does not exceed the maximum value of the signal that can be processed by the detector 5 (dynamic range) or the threshold, the detection signal of the detector 5 may be used as the detection data reflecting the sample state of the irradiation region R in the same manner as in the conventional art.

Although the above embodiment has been described with an example in which the electron beam applicator 1 is a scanning electron microscope and an electron beam inspection device, the electron beam applicator 1 is not particularly limited as long as it can detect secondary electrons, backscattered electrons, characteristic X-rays, Auger electrons, cathodoluminescence, or transmitted electrons. The electron beam applicator 1 other than a scanning electron microscope and an electron beam inspection device may be, for example, an Auger electron spectrometer, a cathodoluminescence device, an X-ray analyzer, a transmission electron microscope (TEM), a scanning transmission electron microscope (STEM), or the like.

Note that FIG. 2A illustrates the example of the scanning type electron beam applicator that irradiates the irradiation region R of the irradiation target S with the electron beam B while deflecting the electron beam B. Alternatively, the position of the excitation light L irradiated on the photocathode 3 from the light source 2 may be scanned. Further alternatively, the photocathode 3 may be irradiated with multiple excitation lights. Even when scanning with the excitation light L is performed or irradiation with multiple excitation lights L is simultaneously performed, quantity of light adjustment data reflecting the sample state of the irradiation region R is obtained by adjusting the quantity of light reaching the photocathode 3 from the light source 2 so that the signal intensity of the detection signal of the emission quantity data SB related to emission from the irradiation region R is the preset value.

Next, the detection data creation method will be described with reference to FIG. 4. The detection data creation method includes an electron beam irradiation step (ST1), a detection step (ST2), a quantity of light adjustment step (ST3), and a detection data output step (ST4). The electron beam irradiation step (ST1) is to irradiate the irradiation region R of the irradiation target S with the electron beam B. The detection step (ST2) is to detect the emission quantity data SB related to emission from the irradiation target S irradiated with the electron beam B by using the detector 5 and generate a detection signal. The quantity of light adjustment step (ST3) is to adjust the quantity of light reaching the photocathode 3 from the light source 2 so that the signal intensity of the detection signal is a preset value. Note that the quantity of light adjustment step is not particularly limited as long as it is possible to adjust the quantity of light reaching the photocathode 3 from the light source 2. For example, the quantity of light can be adjusted by direct control of the power of the light source 2. Further, a quantity of light adjustment member 21 such as a liquid crystal shutter may be arranged between the light source 2 and the photocathode 3, and the control unit 6 may control the quantity of light adjustment member 21 to adjust the quantity of light reaching the photocathode 3. When the control unit 6 controls the quantity of light adjustment member 21, the adjustment data of the quantity of light adjustment member 21 is the data reflecting the sample state of the irradiation region R. The electron beam irradiation step (ST1), the detection step (ST2), and the quantity of light adjustment step (ST3) need to be repeated until the signal intensity of the detection signal becomes the preset value. The detection data output step (ST4) is to output, as detection data on the irradiation region R, the quantity of light adjustment data where the signal intensity of the detection signal is the preset value.

The electron beam applicator and the detection data creation method (hereafter, collectively referred to as "electron beam applicator") disclosed in the present application achieve the following advantageous effects.
(1) The conventional electron beam applicator obtains information on the sample state of the irradiation region R based on the detection signal of the emission quantity data related to emission from the irradiation region R, and this requires a certain degree of dynamic range of the detection sensitivity of the detector 5. In contrast, in the electron beam applicator 1 of the present application, information on the sample state of the irradiation region R is not required to be obtained directly from a detection signal of the detector 5, and the detector 5 is only required to obtain a detection signal. Therefore, while the dynamic range of the detector 5 can be smaller, the dynamic range as the electron beam applicator 1 can be larger. Further, since the dynamic range of the detector 5 can be smaller, costs can be reduced.
(2) When the conventional electron beam applicator 1 is used, the user basically manually adjusts the detection sensitivity. In contrast, since the electron beam applicator 1 of the present application performs feedback control on the quantity of light based on the detection signal, detection data on the sample state of the irradiation region R is obtained by automatic control.
(3) Some irradiation targets S may be samples susceptible to damage by the electron beam B. Since the electron beam applicator 1 of the present application adjusts the quantity of light so that the signal intensity of the detection signal detected by the detector 5 is a preset value, this prevents the irradiation target S from being irradiated with the electron beam B of a higher intensity than is needed. Therefore, damage on the irradiation target S can be reduced. Further, since the quantity of electrons received by the irradiation target S can be reduced, this can achieve a reduced dose.
(4) It is known that the photocathode 3 is deteriorated by irradiation with the excitation light L. Since the electron beam applicator 1 of the present application adjusts the quantity of light so that the signal intensity of the detection signal detected by the detector 5 is the preset value, this prevents the photocathode 3 from being irradiated with more excitation light L than is needed. Therefore, a longer service life of the photocathode 3 is achieved.
(5) The electron beam applicator 1 of the present application uses a feature of being able to quickly change the intensity of the electron beam B to be emitted (the quantity of electrons to be emitted) in accordance with a change in the quantity of light of the excitation light L received by the photocathode 3. In contrast, in the conventional electron beam applicator with a field emission cathode and a thermionic electron emission cathode, it is not possible to quickly change the intensity of an electron beam emitted from the field emission cathode and the thermionic electron emission cathode based on the signal intensity of a detection signal detected by the detector 5. Therefore, the disclosure in the present application is the creation method of detection data and the electron beam applicator based on the novel principle that can be implemented only by using the photocathode 3.

### [Embodiment of Program and Storage Medium]

The embodiment of the electron beam applicator and the detection data creation method described above can be implemented by the control of the control unit 6 of the electron beam applicator 1. Therefore, it is only required that a program created so as to enable execution of each step illustrated in FIG. 4 be installed in the control unit 6. Further, the program may be provided by being stored in the readable storage medium. By installing the program disclosed in the present application in the control unit 6 of the conventional electron beam applicator 1, it is possible to implement the detection data creation method for the irradiation region R based on the novel principle disclosed in the present application.

Although Examples will be presented below to specifically describe the embodiment disclosed in the present application, these Examples are only for the purpose of illustration of the embodiment and are not intended to limit or restrict the scope of the invention disclosed in the present application.

### [EXAMPLE]

### [Fabrication of Electron Beam Applicator 1]

### <Example 1>

A laser source (iBeamSmart by Toptica) was used for the light source 2. For the photocathode 3, an InGaN photocathode was fabricated by a known method described in Daiki SATO et al. 2016 Jpn. J. Appl. Phys. 55 05FH05. EA treatment on the photocathode surface was performed in accordance with a known method. The fabricated electron gun portion was replaced with an electron gun portion of a commercially available SEM. Note that, in the specification of the commercially available SEM, a cold field emission electron source (CFE) was used for the electron gun, and a deflection coil was provided as the electron beam deflector 8. Electron beam acceleration voltage of 30 kV at the maximum and observation at magnification of 1 million at the maximum are possible. The program was created and improved so that the control unit 6 of the electron beam applicator 1 can implement each step described in the embodiment.

### <Comparative Example 1>

The electron beam applicator 1 was fabricated in the same manner as in Example 1 except that the program of the control unit 6 was not modified.

### [Implementation of Creation Method of Detection Data and Image Composition Method]

### <Example 2>

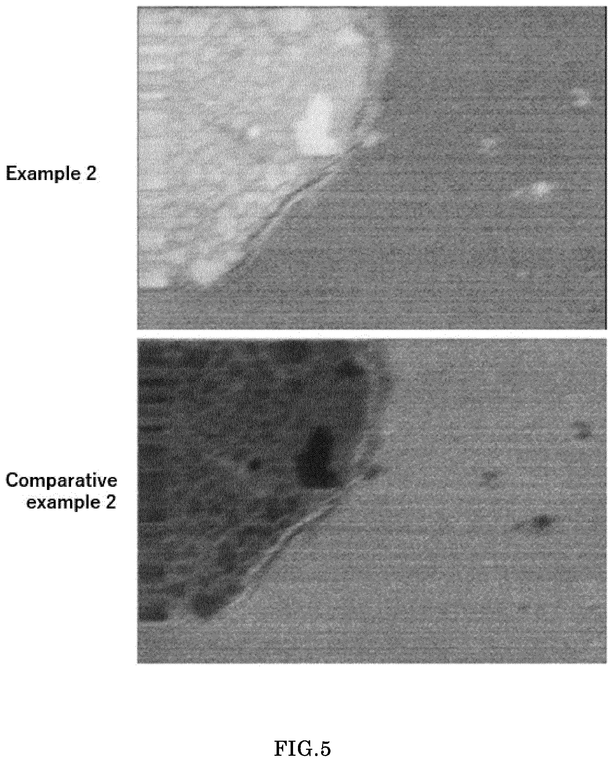

The electron beam applicator 1 fabricated in Example 1 was used to irradiate the irradiation target S with the electron beam B. The quantity of light of the light source 2 was then adjusted so that the signal intensity of the detection signal detected by the detector 5 is a preset value (a value at which the detection signal was the same regardless of the location in the irradiation region R). The quantity of light adjustment data where the signal intensity of the detection signal is the preset value was output as detection data on the irradiation region. Image composition was then performed based on the detection data (data for adjusting the quantity of light (intensity) of the light source 2). The composite image data in Example 2 is represented on the upper photograph in FIG. 5. Note that the experiment conditions were as follows.
- Acceleration voltage: 25 kV
- Magnification: 25,000x
- Intensity of the light source 2 was modulated between 1 mW and 100 mW

### <Comparative Example 2>

The electron beam applicator fabricated in Comparative example 1 was used to capture SEM images of the irradiation target S in the conventional procedure. The image data captured in Comparative example 2 is represented on the lower photograph in FIG. 5. Note that the experiment conditions were as follows.
- Acceleration voltage: 25 kV
- Magnification: 25,000x
- Probe current: 100 pA (current in acquisition of a SEM image)

As illustrated in FIG. 5, in Example 2 and Comparative example 2, the image of the irradiation target S was obtained even with completely different formation principles of images.

### [Industrial Applicability]

According to the creation method of detection data and the image composition method for an irradiation target in an electron beam applicator, the program, the storage medium, and the electron beam applicator disclosed in the present application, it is possible to obtain information on the sample state of the irradiation target S by a new principle that does not require adjustment of the detection sensitivity in accordance with the dynamic range of a detector. Therefore, the creation method of detection data and the image composition method for an irradiation target in an electron beam applicator, the program, the storage medium, and the electron beam applicator disclosed in the present application are useful for business entities that perform inspection, image capturing, or the like of the sample state with an electron microscope, an electron beam inspection device, or the like.

### [List of References]

- 1: electron beam applicator
- 1a: electron gun portion
- 1b: counterpart device
- 2: light source
- 21: quantity of light adjustment member
- 3: photocathode (cathode)
- 4: anode
- 5: detector
- 6: control unit
- 7: power supply
- 8: electron beam deflector
- B: electron beam
- C: circuit
- CB: vacuum chamber
- L: excitation light
- S: irradiation target
- SB: emission quantity data
- R: irradiation region

## Claims

1. A creation method of detection data in an electron beam applicator, wherein the electron beam applicator includes
a light source,
a photocathode configured to generate releasable electrons in response to receiving light from the light source,
an anode configured to form an electric field between the photocathode and the anode and extract the releasable electrons by the formed electric field to form an electron beam,
a detector configured to detect emission quantity data related to emission from an irradiation target irradiated with the electron beam, and
a control unit,
the creation method of detection data comprising:
an electron beam irradiation step of irradiating an irradiation region of the irradiation target with the electron beam;
a detection step of detecting, by the detector, the emission quantity data related to emission from the irradiation region irradiated with the electron beam and generating a detection signal;
a quantity of light adjustment step of adjusting a quantity of light reaching the photocathode from the light source so that a signal intensity of the detection signal is a preset value;
a step of repeating the electron beam irradiation step, the detection step, and the quantity of light adjustment step until the signal intensity of the detection signal becomes the preset value; and
a detection data output step of outputting the quantity of light adjustment data where the signal intensity of the detection signal is the preset value as detection data on the irradiation region.

2. The creation method of detection data according to claim 1, wherein the preset value is the same value regardless of a location in the irradiation region.

3. The creation method of detection data according to claim 1, wherein the electron beam applicator is
a scanning electron microscope,
an electron beam inspection device,
an Auger electron spectrometer,
a cathodoluminescence device,
an X-ray analyzer,
a transmission electron microscope, or
a scanning transmission electron microscope.

4. The creation method of detection data according to claim 2, wherein the electron beam applicator is
a scanning electron microscope,
an electron beam inspection device,
an Auger electron spectrometer,
a cathodoluminescence device,
an X-ray analyzer,
a transmission electron microscope, or
a scanning transmission electron microscope.

5. An image composition method for an irradiation target in an electron beam applicator, the image composition method comprising:
an image composition step of compositing an image of an irradiation region of the irradiation target from detection data obtained by the creation method of detection data according to claim 1.

6. An image composition method for an irradiation target in an electron beam applicator, the image composition method comprising:
an image composition step of compositing an image of an irradiation region of the irradiation target from detection data obtained by the creation method of detection data according to claim 2.

7. An image composition method for an irradiation target in an electron beam applicator, the image composition method comprising:
an image composition step of compositing an image of an irradiation region of the irradiation target from detection data obtained by the creation method of detection data according to claim 3.

8. An image composition method for an irradiation target in an electron beam applicator, the image composition method comprising:
an image composition step of compositing an image of an irradiation region of the irradiation target from detection data obtained by the creation method of detection data according to claim 4.

9. A program that causes the control unit of the electron beam applicator to perform each step according to any one of claims 1 to 8.

10. A computer readable storage medium storing the program according to claim 9.

11. An electron beam applicator comprising:
a light source;
a photocathode configured to generate releasable electrons in response to receiving light from the light source;
an anode configured to form an electric field between the photocathode and the anode and extract the releasable electrons by the formed electric field to form an electron beam;
a detector configured to detect emission quantity data related to emission from an irradiation target irradiated with the electron beam; and
a control unit,
wherein the control unit implements control to perform
an electron beam irradiation step of irradiating an irradiation region of the irradiation target with the electron beam,
a detection step of detecting, by the detector, the emission quantity data related to emission from the irradiation region irradiated with the electron beam and generating a detection signal,
a quantity of light adjustment step of adjusting a quantity of light reaching the photocathode from the light source so that a signal intensity of the detection signal is a preset value,
a step of repeating the electron beam irradiation step, the detection step, and the quantity of light adjustment step until the signal intensity of the detection signal becomes the preset value, and
a detection data output step of outputting the quantity of light adjustment data where the signal intensity of the detection signal is the preset value as detection data on the irradiation region.

12. The electron beam applicator according to claim 11, wherein the preset value is the same value regardless of a location in the irradiation region.

13. The electron beam applicator according to claim 11 or 12, wherein the control unit implements control to perform an image composition step of compositing an image of an irradiation region of the irradiation target from the detection data.

14. The electron beam applicator according to claim 11 or 12, wherein the electron beam applicator is
a scanning electron microscope,
an electron beam inspection device,
an Auger electron spectrometer,
a cathodoluminescence device,
an X-ray analyzer,
a transmission electron microscope, or
a scanning transmission electron microscope.

15. The electron beam applicator according to claim 13, wherein the electron beam applicator is
a scanning electron microscope,
an electron beam inspection device,
an Auger electron spectrometer,
a cathodoluminescence device,
an X-ray analyzer,
a transmission electron microscope, or
a scanning transmission electron microscope.
